# EUROPEAN PATENT SPECIFICATION

(11) **EP 3 324 445 B1**
(45) Date of publication and mention of the grant of the patent: **05.01.2022**
(21) Application number: 17200383.2
(22) Date of filing: 07.11.2017
(51) Int. Cl.: H01L 31/0224

(54) **SOLAR CELL AND SOLAR CELL PANEL INCLUDING THE SAME**
SOLARZELLE UND SOLARZELLENPANEL DAMIT
CELLULE SOLAIRE ET PANNEAU DE CELLULE SOLAIRE LA COMPRENANT

(30) Priority: 17.11.2016 KR 20160153207
(43) Date of publication of application: 23.05.2018
(73) Proprietor: LG Electronics Inc., Yeongdeungpo-gu Seoul 07336 (KR)
(72) Inventor: JIN, Yongduk, 08592 Seoul (KR); CHO, Sungyong, 08592 Seoul (KR); SHIM, Kyungjin, 08592 Seoul (KR)
(74) Representative: Katérle, Axel

(56) References cited:
- WO-A1-2013/099039
- WO-A1-2016/157683
- JP-A- 2015 528 645
- US-A1- 2011 168 255
- US-A1- 2011 247 688
- US-A1- 2012 138 141
- US-A1- 2014 190 563
- US-A1- 2016 093 752

## Description

### BACKGROUND OF THE INVENTION

### Field of the Invention

Embodiments of the invention relate to a solar cell and a solar cell panel including the same, and more particularly to a solar cell having improved electrode structure and a solar cell panel including the same.

### Description of the Related Art

Recently, as existing energy sources such as petroleum and coal are expected to be depleted, interests in alternative energy sources for replacing the existing energy sources are increasing. Among the alternative energy sources, solar cells for generating electric energy from solar energy have been particularly spotlighted.

A plurality of solar cells are connected in series or in parallel by a ribbon. The plurality of solar cells are manufactured in a form of a solar cell panel by a packaging process for protecting the plurality of solar cells. Solar panels require long-term reliability because they must generate electricity for a long time in various environments. In this instance, conventionally, the plurality of solar cells are connected by the ribbon.

However, when the solar cell is connected using a solder-coated ribbon having a large width of about 1.5 mm, since the solar cell can cause optical loss due to the large width of the ribbon, the number of ribbons disposed in the solar cell should be reduced. On the other hand, when the number of the ribbons is increased in order to reduce a movement distance of carriers, the resistance is lowered, but the output may be largely lowered due to the shading loss.

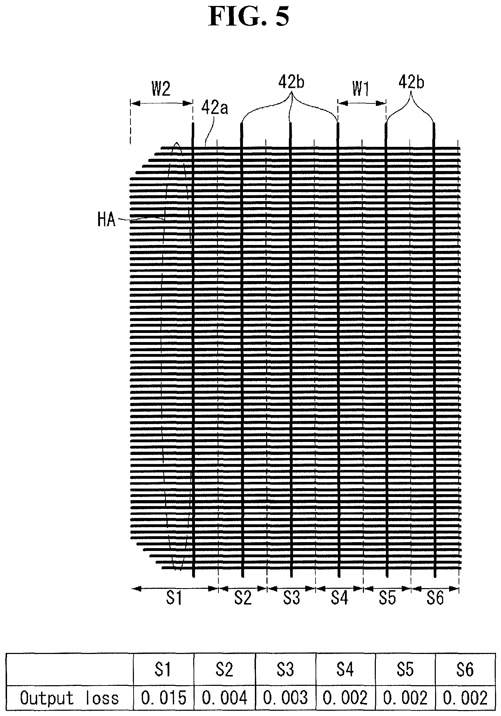

US 2012/138141 A1 relates to a solar cell including a ribbon 143 which connects electrode layers 152 formed on surfaces of two solar cells. With regard to Fig. 5, a bus bar electrode 310 is shorter than a typical bus bar electrode as an upper portion of the bus bar electrode 310 is not formed or partially removed. In this regard, the light incident area can increase since the sun light can penetrate the upper portion of the bus bar electrode 310 where the ribbon is not connected.

### SUMMARY OF THE INVENTION

An object of the invention is to provide a solar cell and a solar cell panel including the same that can improve the output and reliability of the solar cell panel.

In one aspect, there is provided a solar cell according to claim

The plurality of finger lines includes a finger portion positioned in the second area, and an extension portion positioned in the first area and having a width greater than a width of the finger portion. A width of the extension portion may be 1.5 to 3.0 times a width of the finger portion.

A width of the extension portion may gradually decrease toward the one end of the semiconductor substrate. A maximum width of the extension portion may be 1.5 to 3.0 times the width of the finger portion, and a minimum width of the extension portion may be equal to or less than the width of the finger portion.

The plurality of finger lines may include first finger lines disposed in the first area and second finger lines disposed in the second area, and a number of the first finger lines is greater than a number of the second finger lines.

Each first finger line may form a first pitch with a neighboring first finger line in the second direction, and each second finger line may form a second pitch with a neighboring second finger line in the second direction, the second pitch being greater than the first pitch.

The first width may be 1/11 to 1/9.5 of a width of the semiconductor substrate in the first direction.

The second bus bar is positioned apart from a neighboring second bus bar in the first direction by a second width smaller than the first width.

A number of the plurality of bus bars may be 10 to 20.

In another aspect, there is provided a solar cell panel including a front substrate, a back substrate facing the front substrate, a plurality of solar cells positioned between the front substrate and the back substrate and connected to neighboring solar cells by 10 to 20 of a plurality of wirings, and a sealing material surrounding the plurality of solar cells.

In a solar cell and a solar cell panel including the solar cell according to an embodiment of the invention, the optical loss can be minimized by using thin bus bars and/or wire-like wirings. The movement distance of the carriers can be reduced by increasing the number of bus bars and/or wirings. Thus, the efficiency of the solar cell and the output of the solar cell panel can be improved.

According to an embodiment of the invention, the shape of the electrodes is configured differently depending on the position, thereby compensating for the output loss where the output loss is relatively high.

### BRIEF DESCRIPTION OF THE DRAWINGS

The accompanying drawings show schematized drawings to illustrate easily the invention. Therefore, the drawings may be different from actual ones.
FIG. 1 is a perspective view illustrating a solar cell panel according to an embodiment of the invention.
FIG. 2 is a cross-sectional view taken along a line II-II in FIG. 1.
FIG. 3 illustrates an example of a solar cell and a wiring connected to the solar cell included in a solar cell panel according to an embodiment of the invention.
FIG. 4 is a perspective view schematically illustrating a first solar cell and a second solar cell connected by wirings and included in a solar cell panel of FIG. 1.
FIG. 5 is a front plan view of a solar cell shown in FIG. 4
FIG. 6 illustrates a result of experiment to determine output loss per area in a solar cell.
FIGS. 7 to 12 illustrate electrodes of a solar cell according to some embodiments.
FIGS. 13 and 14 illustrate a result of experiment to determine effects of embodiments of the invention.
FIG. 15 illustrates an embodiment in which an extension portion is formed in an outer area including a chamfer in a back contact type solar cell.

### DETAILED DESCRIPTION OF THE EMBODIMENTS

Reference will now be made in detail to embodiments of the invention, examples of which are illustrated in the accompanying drawings.

This invention may, however, be embodied in many different forms and should not be construed as limited to the embodiments set forth herein. Wherever possible, the same reference numbers will be used throughout the drawings to refer to the same or like parts. It will be noted that a detailed description of known arts will be omitted if it is determined that the detailed description of the known arts can obscure the embodiments of the invention. In addition, the various embodiments shown in the drawings are illustrative and may not be drawn to scale to facilitate illustration. The shape or structure can also be illustrated by simplicity.

Hereinafter, a solar cell and a solar cell panel according to an embodiment of the invention will be described in detail with reference to the accompanying drawings.

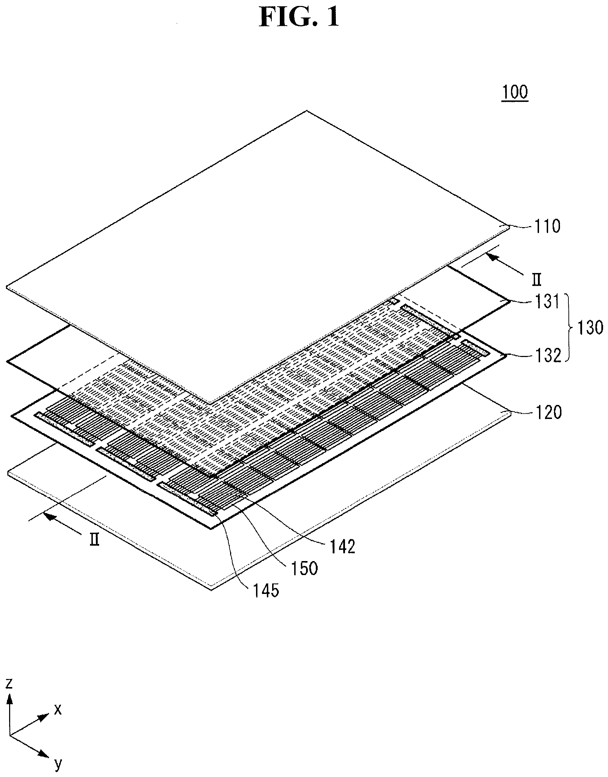

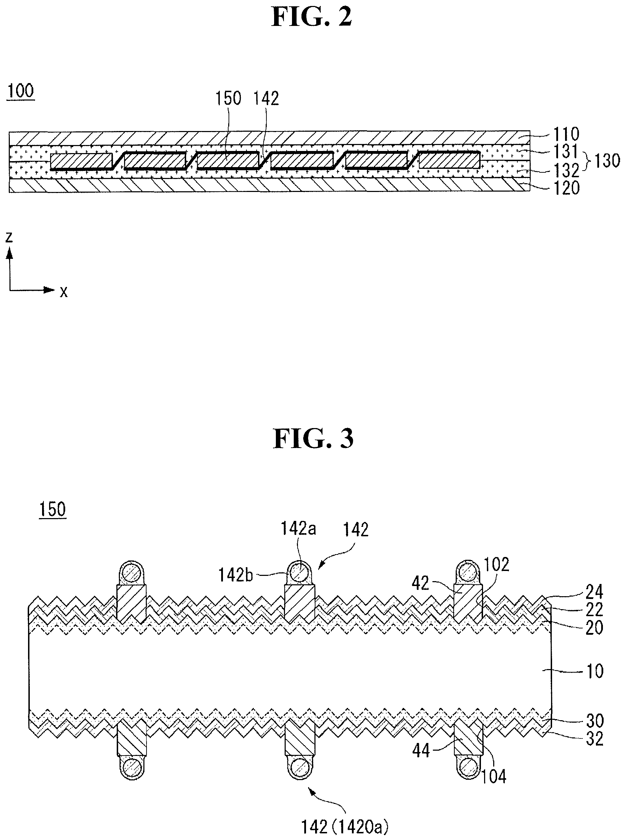

FIG. 1 is a perspective view illustrating a solar cell panel according to an embodiment of the invention. FIG. 2 is a cross-sectional view taken along a line II-II in FIG. 1.

Referring to FIGS. 1 and 2, a solar cell panel 100 according to an embodiment of the invention includes a plurality of solar cells 150 and a plurality of wirings 142 for electrically connecting the plurality of solar cells 150. The solar cell panel 100 includes a sealing material 130 that surrounds and seals the plurality of solar cells 150 and the plurality of wirings 142 that connects the plurality of solar cells 150, a front substrate 110 positioned on a front surface of the solar cell 150 on the sealing material 130, and a back substrate 120 positioned on a back surface of the solar cell 150 under the sealing material 130. This will be explained in more detail.

First, the solar cell 150 includes a photoelectric conversion unit that converts sunlight into electric energy, and an electrode that is electrically connected to the photoelectric conversion unit and collects and transmits a current. The plurality of solar cells 150 are electrically connected in series or in parallel by the plurality of wirings 142. The plurality of wirings 142 are disposed between two neighboring solar cells 150 to electrically connect the solar cells 150.

A bus ribbon 145 is connected by the wirings 142. The bus ribbon 145 connects both ends of the wirings 142 of a string in which the solar cell forms a row. Various known ones can be used as the bus ribbon 145.

The sealing material 130 includes a first sealing material 131 positioned on a front surface of a plurality of strings connected by the bus ribbon 145 and a second sealing material 132 positioned on a back surface of the plurality of strings. The first sealing material 131 and the second sealing material 132 may be made of an insulating material having transparency and adhesion so as to prevent an inflow of moisture and oxygen. For example, the first sealing material 131 and the second sealing material 132 may be made of an ethylene-vinyl acetate copolymer resin (EVA), a polyvinyl butyral, a silicon resin, an ester resin, an olefin resin, or the like. The solar cell panel 100 is formed by integrating the back substrate 120, the second sealing material 132, the solar cell 150, the first sealing material 131, and the front substrate 110 by a lamination process.

The front substrate 110 is positioned on the first sealing material 131 to form a front surface of the solar cell panel 100. The back substrate 120 is positioned under the second sealing material 132 to form a back surface of the solar cell panel 100. The front substrate 110 and the back substrate 120 may be formed of an insulating material capable of protecting the solar cell 150 from external shock, moisture, ultraviolet rays, or the like.

The front substrate 110 may be made of a transparent material through which light can be transmitted. The back substrate 120 may be formed of a sheet made of a transparent material, a non-transparent material, a reflective material, or the like.

For example, the front substrate 110 is a glass substrate, and the back substrate 120 is a resin in a form of a film or a sheet. The back substrate 120 may have a TPT

(Tedlar/PET/Tedlar) type or include a polyvinylidene fluoride (PVDF) resin layer formed on at least one side of a base film (for example, polyethylene terephthalate (PET)).

Hereinafter, referring to FIG. 3, an example of a solar cell and a wiring connected to the solar cell used in a solar cell panel according to an embodiment of the invention will be described.

FIG. 3 is a partial cross-sectional view illustrating an example of a solar cell and a wiring connected to the solar cell included in a solar cell panel of FIG. 1.

Referring to FIG. 3, the solar cell 150 includes a semiconductor substrate 10, conductivity type regions 20 and 30 formed on and under the semiconductor substrate 10, respectively, and electrodes 42 and 44 connected to the conductivity type regions 20 and 30, respectively.

The conductivity type regions 20 and 30 are divided into a first conductivity type region 20 (for example, p+ region) and a second conductivity type region 30 (for example, n+ region) depending on an impurity type. The electrodes 42 and 44 include a first electrode 42 connected to the first conductivity type region 20 and a second electrode 44 connected to the second conductivity type region 30.

The semiconductor substrate 10 may include a first or a second conductivity type impurity at a lower concentration than the conductivity type regions 20 and 30. For example, the semiconductor substrate 10 may have a second conductivity type. The semiconductor substrate 10 may be made of a single crystalline semiconductor (for example, a single crystal or polycrystalline semiconductor, a single crystal or polycrystalline silicon, particularly a single crystal silicon).

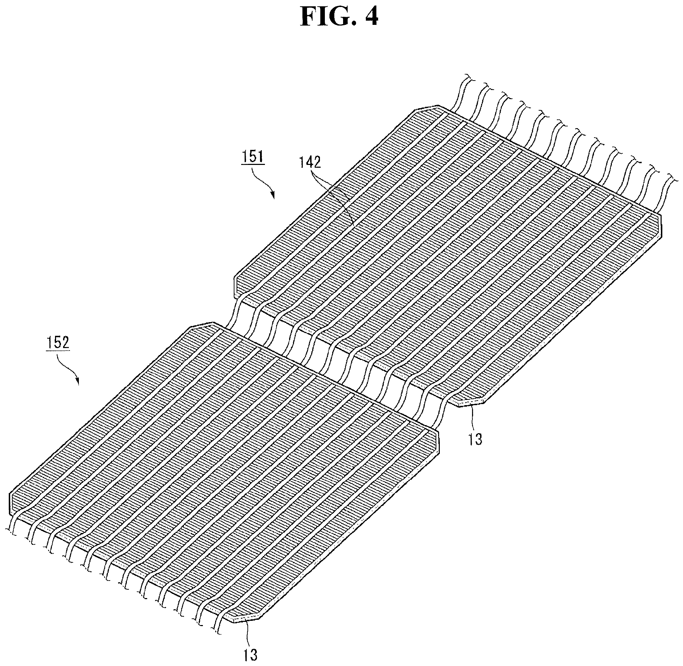

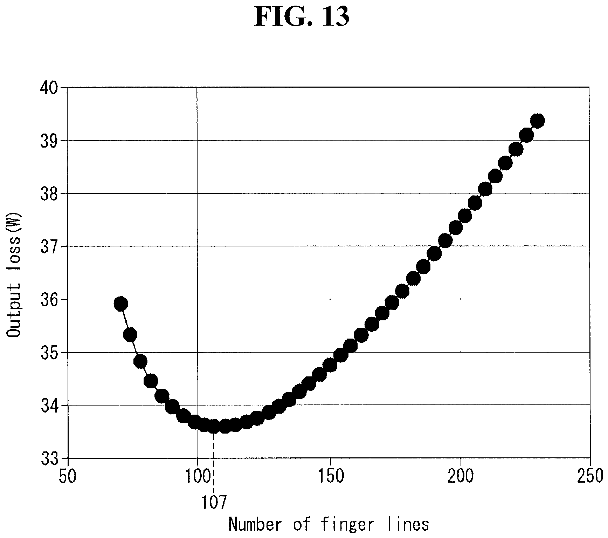

In one example form, the semiconductor substrate 10 is made of a single crystal silicon having high crystallinity and few defects and having excellent electrical characteristics. The semiconductor substrate 10 includes a chamfer (FIGS. 4 and 13) with an angled edge due to a manufacturing process.

A front surface and a back surface of the semiconductor substrate 10 may have a texturing structure of unevenness capable of minimizing reflection.

The first conductivity type region 20 is formed on one surface (for example, a front surface) of the semiconductor substrate 10 and a second conductivity type region 30 is formed on the other surface (for example, a back surface) of the semiconductor substrate 10. In this instance, impurities in the first and second conductivity type regions 20 and 30 have a higher doping concentration than that of the semiconductor substrate.

One region of the first and second conductivity type regions 20 and 30 having a conductivity type different from that of the semiconductor substrate 10 forms an emitter region. The emitter region forms a p-n junction with the semiconductor substrate 10 to generate carriers by photoelectric conversion.

Another region of the first and second conductivity type regions 20 and 30 having the same conductivity type as that of the semiconductor substrate 10 forms a surface field region. The surface field region forms a surface field that prevents carriers from being lost by recombination on a surface of the semiconductor substrate 10.

An insulating layer such as a first passivation layer 22, a second passivation layer 32, and an anti-reflection layer 24 may be formed on the surface of the semiconductor substrate 10. More specifically, the first passivation layer 22 may be formed (for example, in contact) on the front surface of the semiconductor substrate 10, more precisely on the first conductivity type region 20 formed on the semiconductor substrate 10. The anti-reflection layer 24 may be formed (for example, in contact) on the first passivation layer 22. The second passivation layer 32 may be formed (for example, in contact) under the back surface of the semiconductor substrate 10, more precisely under the second conductivity type region 30 formed under the semiconductor substrate 10.

The first passivation layer 22 or the second passivation layer 32 is formed in contact with the semiconductor substrate 10 to passivate defects existing in the front surface or bulk of the semiconductor substrate 10.

The anti-reflection layer 24 reduces a reflectance of light incident on the front surface of the semiconductor substrate 10, thereby increasing an amount of light reaching the p-n junction.

The first passivation layer 22, the anti-reflection layer 24, and the second passivation layer 32 may be formed of various materials. For example, the first passivation layer 22, the anti-reflection layer 24, or the passivation layer 32 may be formed of a silicon nitride layer, a silicon nitride layer including hydrogen, a silicon oxide layer, a silicon oxynitride layer, an aluminum oxide layer, a silicon carbide layer, any one single layer selected from a group consisting of MgF₂, ZnS, TiO₂, and CeO₂, or a multilayer structure in which two or more layers are combined.

The first electrode 42 is electrically connected (for example, in contact) to the first conductivity type region 20 and the second electrode 44 is electrically connected (for example, in contact) to the second conductivity type region 30. The first and second electrodes 42 and 44 are made of various conductive materials (for example, metal). The first and second electrodes 42 and 44 have different shapes depending on their positions in order to reduce an output loss. This will be described in detail later.

As described above, in this embodiment, the first and second electrodes 42 and 44 of the solar cell 150 have a certain pattern, so that the solar cell 150 may have a bi-facial structure in which light can be incident on the front surface and the back surface of the semiconductor substrate 10.

The solar cell 150 described above is electrically connected to the neighboring solar cell 150 by the wirings 142 that are joined (for example, soldered) on the first electrode 42 or the second electrode 44. This will be described in more detail with reference to FIG. 4 together with FIGS. 1 to 3.

FIG. 4 is a perspective view schematically illustrating a first solar cell 151 and a second solar cell 152 connected by wirings 142 and included in a solar cell panel 100 of FIG. 1. In FIG. 4, the first and second solar cells 151 and 152 are schematically shown only with the semiconductor substrate 10 and the electrodes 42 and 44.

As shown in FIG. 4, two neighboring solar cells 150 (for example, the first solar cell 151 and the second solar cell 152) among a plurality of solar cells 150 are connected by a plurality of wirings 142. The wirings 142 connects the first electrode 42 disposed on a front surface of the first solar cell 151 and the second electrode 44 disposed under a back surface of the second solar cell 152 immediately adjacent to the first solar cell 151.

Hereinafter, only the first solar cell and the second solar cell will be described. However, the connection of the solar cells by the wirings 142 is also applied to other solar cells.

In this embodiment, the wirings 142 can be divided into three parts depending on their positions. A first part is a part connected to the first electrode 42 on the front surface of the first solar cell 151. A second part is a part connected to the second electrode 44 under the back surface of the second solar cell 152. A third part is a part connecting the first part and the second part between the first solar cell 151 and the second solar cell 152.

The wirings 142 are positioned across the second solar cell 152 in a part of an area of the second solar cell 152 after crossing the first solar cell 151 in a part of an area of the first solar cell 151.

The wirings 142 are arranged so as to extend along a bus bar 42b in FIG. 5 while contacting and joining the bus bar 42b on the bus bar at the first and second electrodes 42 and 44. As a result, the wirings 142 and the first and second electrodes 42 and 44 are continuously in contact with each other, so that a bonding strength and a contact resistance can be reduced.

On the basis of one surface of each solar cell 150, the plurality of wirings 142 are provided to improve electrical connection characteristics of the neighboring solar cells 150. Especially, the wirings 142 are formed of a wire having a width smaller than that of a ribbon having a relatively wide width (for example, 1 mm to 2 mm) which is used conventionally, so that this embodiment uses a larger number of wirings 142 than the number of the conventional ribbons (for example, 2 to 5) on the basis of one surface of each solar cell 150.

For example, the wirings 142 includes a core layer (142a in FIG. 3, hereinafter the same) made of metal and a solder layer (142b in FIG. 3, hereinafter the same) that is coated with a thin thickness on the surface of the core layer 142a and is solderable with the electrodes 42 and 44 by including soldering materials.

For example, the core layer 142a may contain Ni, Cu, Ag, or Al as a main material (for example, a material containing 50 wt% or more, or more specifically, a material containing 90 wt% or more). The solder layer 142b may contain a material such as Pb, Sn, SnIn, SnBi, SnPb, SnPbAg, SnCuAg, or SnCu, and the like as a main material. However, the invention is not limited thereto, and the core layer 142a and the solder layer 142b may contain various materials.

In this embodiment, since the wire having a width smaller than that of the conventional ribbon is used, a shading loss caused by the ribbon can be reduced. In addition, since the wirings 142 of this embodiment use a larger number of wirings than the number of the conventional ribbons, a movement distance of carriers collected in the wirings 142 can be reduced to effectively collect the carriers having a short life time.

In addition, the wirings 142 according to an embodiment of the invention may include round portions. That is, cross sections of the wirings 142 may have a surface with a circle, an ellipse, or a curved line. Thus, the wirings 142 can induce reflection or scattered reflection. However, the invention is not limited thereto, and the wirings 142 may have a polygonal shape such as a quadrangular shape or the like and may have various other shapes.

In this embodiment, the wirings 142 have a width (or a diameter) less than 1 mm, for example, 250 µm to 500 µm. The width of the wirings 142 means a width when the wirings 142 exist alone before being bonded to the first or second electrodes 42, 44. As an example form, the wirings 142 are directly bonded to the first or second electrodes 42, 44 by soldering which melts the solder layer (142b of FIG. 3) and directly bonds the wirings to the first or second electrodes 42, 44.

When the width of the wirings 142 is less than 250 µm, a strength of the wirings 142 may not be sufficient, and a contact area of the electrodes 42 and 44 is too small, so that the contact resistance is too large and a desired sufficient bonding strength cannot be obtained. When the width of the wirings 142 is 1 mm or more, a cost of the wirings 142 increases and the wirings 142 interferes with an incidence of light incident on the front surface of the solar cell 150, so that a shading loss increases too much. Considering this point, the width of the wirings is, for example, 250 µm to 500 µm.

In this embodiment, the number of wirings 142 used for connecting the first solar cell 151 and the second solar cell 152 is 10 or more, for example, 10 to 20.

However, the invention is not limited thereto. The invention can be modified by variables such as a width, a pitch (a distance between electrodes), and the number of the first and second electrodes 42 and 44 to be described later. For example, as the widths of the first and second electrodes 42 and 44 are small, the number of the wirings 142 should be large. As the width is large, the number of the wirings 142 should be small.

Hereinafter, referring to FIG. 5 together with FIGS. 1 to 4, an example of the electrodes 42 and 44 of the solar cell 150 to which the wirings 142 described above is attached will be described in detail. Hereinafter, the first electrode 42 will be described in detail with reference to FIG. 5, but any one of the first and second electrodes 42 and 44 may be applicable to the following description. The other one of the first and second electrodes 42 and 44 may be the same as the following electrode. The other one of the first and second electrodes 42 and 44 has the same or similar shape as the following electrodes but may have a different size, interval, pitch, and the like. The other one of the first and second electrodes 42 and 44 may have a completely different shape from the following electrodes.

FIG. 5 is a front plan view of a solar cell shown in FIG. 4 and illustrates a first electrode 42 as a main view.

Referring to FIGS. 1 to 5, in this embodiment, the first electrode 42 includes a plurality of finger lines 42a extending in a first direction (a horizontal direction in the drawing) and positioned in parallel with each other and a bus bar 42b formed in a second direction (a vertical direction in the drawing) that intersects (for example, orthogonal) with the finger lines 42a, connected electrically to the finger lines 42a, and connected to or attached to the wirings 142.

The plurality of finger lines 42a are apart from each other with a uniform width and pitch. The finger lines 42a are arranged to have different widths and numbers depending on positions, which will be described later in detail.

A plurality of bus bars 42b may be positioned so as to correspond to the portions where the wirings 142 for connection with the neighboring solar cells 150 are located. The plurality of bus bars 42b are provided to correspond to the wirings 142 in a one-to-one correspondence. Accordingly, in this embodiment, the bus bars 42b are provided in the same number as the wirings 142 on the basis of one surface of the solar cell 150.

In this embodiment, the bus bar 42b includes a line portion 421 and a plurality of pad portions 423 having a greater width than that of the line portion 421 and selectively positioned at intervals in the line portion 421.

The line portion 421 connects the plurality of finger lines 42a and the pad portions 423 to provide a path by which the carriers can bypass when some finger lines 42a are broken. A width of the line portion 421 measured in the first direction may be smaller than a width of the pad portion 423 and the wirings 142, and may be equal to or greater than a width of the finger lines 42a measured in the second direction.

The width of the line portion 421 is thin. Thus, the wiring 142 is bonded to the line portion 421, or the wiring 142 can be positioned on the line portion 421 without being bonded to the line portion 421.

The pad portion 423 has a relatively wide width and is an area where the wiring 142 is substantially attached. The width of the pad portion 423 measured in the first direction may be greater than the width of the line portion 421 measured in the first direction and the width of the finger line 42a measured in the second direction. The width of the pad portion 423 measured in the first direction may be equal to or greater than the width of the wiring 142 as compared with the wiring 142.

A length of the pad portion 423 measured in the second direction is greater than the width of the finger line 42a. The pad portion 423 can improve an adhesion between the wiring 142 and the bus bar 42b and reduce the contact resistance.

The invention can minimize an optical loss by using the bus bars 42b having such a small width and/or wire-shaped wirings 142 and reduce a movement distance of the carriers by increasing the number of the bus bars 42b and/or the wirings 142. Accordingly, an efficiency of the solar cell 150 and an output of the solar cell panel 100 can be improved.

Meanwhile, a large number of single crystal silicon wafers are used as semiconductor substrates for manufacturing high efficiency solar cells. The single crystal silicon wafers have high crystallinity, few defects and excellent electrical characteristics. However, since the crystals of the single crystal silicon wafers are grown in one direction, the single crystal silicon wafers have disadvantage that it is easily broken by an impact along the crystal growth direction. Particularly, since the crystal growth direction of the single crystal silicon wafer is a diagonal direction, it is easily broken by an impact applied to the chamfer 13, so care must be taken in manufacturing the solar cell panel.

For reference, a single crystal silicon wafer used in a solar cell is formed by blocking an ingot grown in a cylindrical shape into a substantially tetragonal shape, and then slicing the same. However, in order to prevent breakage in the process of blocking, instead of a complete tetragonal shape, each corner of the quadrangle is processed to have a pseudo-square shape with an inclination (corresponding to an arc of the cylindrical ingot).

In order to effectively collect the carriers produced in the solar cell without an output loss, a plurality of wirings arranged on one surface of the solar cell must be arranged evenly. Accordingly, the bus bars 42 to be bonded/contacted with the wirings 142 should be arranged so as to be evenly spaced.

Meanwhile, the output loss has a value obtained by multiplying a square of a current to be collected by a resistance value. Since the output loss is proportional to the square of the current, when an amount of the current is biased to one side, the resulting output loss is increased to the square of the amount. Therefore, it is preferable to arrange all the intervals between the wirings uniformly. The intervals are formed by dividing the width of the solar cell by the number of the wirings plus (+) 1.

However, in an embodiment of the invention, for example, since 10 to 20 wirings 142 are used on the front surface or the back surface of one solar cell, the wirings 142 can be positioned so as to cross the chamfer 13.

For example, the size (width x length) of the so-called M4 wafer is 16.17 cm x 16.17 cm, and the width and length of the chamfer is 1.49 cm. Therefore, assuming that twelve wirings 142 are disposed on either surface of the solar cell, an interval between the bus bars 42b disposed at positions corresponding to the wirings 142 is, for example, 1.24 cm.

By comparison, since the width and length of the chamfer is 1.49 cm, each of two outermost bus bars (a bus bar positioned closest to the chamfer 13 is hereinafter referred to as a first bus bar and a reference numeral 42b1 and bus bars positioned between the first bus bars are hereinafter referred to as second bus bars and a reference numeral 42b2) of the twelve bus bars 42b should be positioned inside the chamfer 13. However, in this instance, in a process of connecting the wirings 142 to the solar cell 150, or in a process of lamination, there is a possibility that an impact is applied to the chamfer 13 to break the solar cell. Actually, the inventors of the invention have also experienced problems in that the solar cell is broken even in a result of an experiment.

Considering this point, in this embodiment, a second width W2 between the first bus bars 42b1 and ends 10a and 10b of the semiconductor substrate 10 is greater than a width C1 of the chamfer 13 in the first direction. The first bus bar 42b1 is positioned to offset from the ends 10a and 10b of the semiconductor substrate 10 to an inside of the semiconductor substrate 10 by "W2-C1". As a result, the wiring 142 placed on the first bus bar 42b1 is positioned inside the chamfer 13 by the offset interval W2 - C1, so that the wiring 142 is not positioned on the chamfer 13.

Considering that the width of the wiring 142 is 250 µm to 500 µm in an example form, the offset interval W2-C1 must be at least 250 µm, so that the wiring 142 can be positioned to offset from the chamfer 13.

For example, considering a manufacturing environment, such as work yield or production yield, the offset interval W2-C1 should be greater than 0.5 mm and less than 1 mm. When the offset interval W2-C1 is less than 0.5 mm, the wiring 143 positioned in the first bus bar 42b1 can cross the chamfer 13. When the offset interval W2-C1 is greater than 1 mm, a first width W1 of the second bus bar 42b2 becomes too narrow and the second width W2 becomes too wide.

A first area S1 in which the first bus bar 42b1 collects carriers is larger than second to eleventh areas S2 to S11 in which each second bus bar 42b2 collects carriers. Therefore, there is a problem that an output loss in the first area S1 becomes relatively large.

Also, in a process of bonding the wiring 142 to the first bus bar 42b1 and the second bus bar 42b2, as heat shrinkage and expansion occur in the longitudinal direction of the wiring, the semiconductor substrate 10 is bent or severely cracked. However, as the first bus bar 42b1 enters the inside of the semiconductor substrate, the first width W1 gradually decreases while the second width W2 gradually increases. As a result, a thermal stress transmitted to the semiconductor substrate 10 through the first bus bar 42b1 and the second bus bar 42b2 is transmitted unevenly depending on the positions, a problem that the semiconductor substrate 10 easily deforms also occurs.

In an embodiment of the invention, the first bus bar 42b1 positioned at both edges of the semiconductor substrate 10 is positioned apart from the end of the semiconductor substrate 10 by the second width W2. On the other hand, the second bus bar 42b2 positioned between the first bus bars 42b1 is positioned apart from the neighboring second bus bar 42b2 by the first width W1 smaller than the second width W2.

The first width W1 is a value obtained by equally dividing a width between the first bus bars 42b1 positioned at both edges of the semiconductor substrate 10 by the number of the second bus bars 42b2. That is, the first width W1 can be obtained as follows.

W1 = (total length (L) of semiconductor substrate - 2 x W2) / (number of second bus bars + 1)

As a result, the first width W1 is smaller than the second width W2. In an example form, the second bus bar 42b2 is uniformly positioned with the first width W1 between the first bus bars 42b1. Accordingly, the intervals of the second to eleventh areas S2 to S11 for collecting the carriers by the second bus bar 42b2 are all the same. Thus, the same output can be produced in each of the second to eleventh areas S2 to S11.

Meanwhile, FIG. 5 illustrates an experimental result for detecting an output loss per area in the solar cell. This experiment was conducted on a solar cell having twelve bus bars 42, a line resistance of 0.48 Ohm/cm, and 78 finger lines. The output loss is an absolute efficiency. In FIG. 5, only one half of the solar cell is shown because the solar cell has a structure symmetrical to left and right.

As a result of the experiment (on the basis of an absolute value), an output loss occurred by 0.002 in the areas S4 to S6, 0.003 in the area S3, 0.004 in the area S2, and 0.015 in the area S1, which is approximately 7 times higher than that in the areas S4 to S6.

From the experimental results, it can be confirmed that an output loss occurs sharply in a first wiring arranged by the second width W2 at the outermost part.

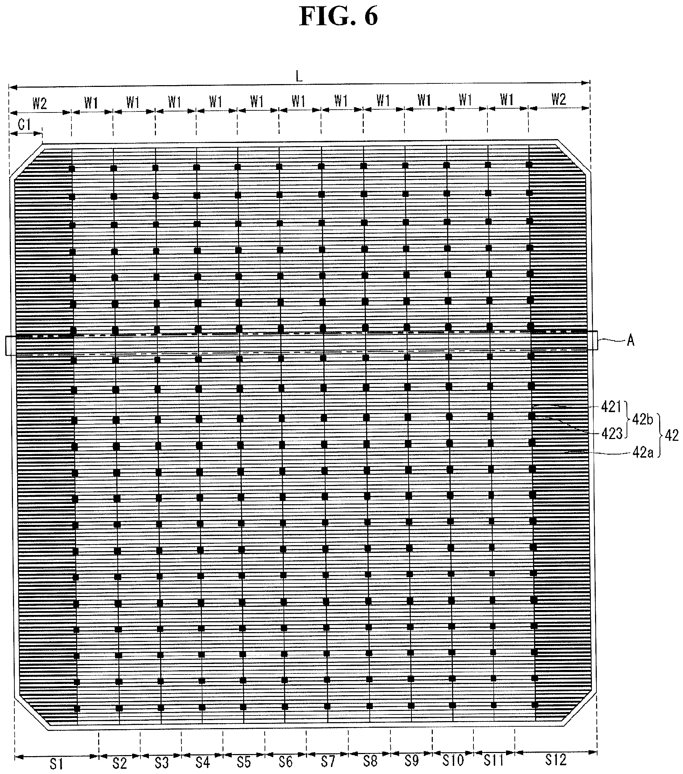

In FIGS. 5 to 7, an amount of current increased sharply in a portion HA immediately adjacent to the first bus bar 42b1 of the area S1 to which the first bus bar 42b1 belongs.

Hereinafter, a configuration of an electrode for compensating for such an output loss will be described in detail. According to an embodiment of the invention, The invention compensates the output loss by configuring a shape (for example, the number or width of the electrode) of the electrodes disposed in the first area S1 and the second area S12 and a shape of the electrodes disposed in the remaining areas S2 to S11 differently.

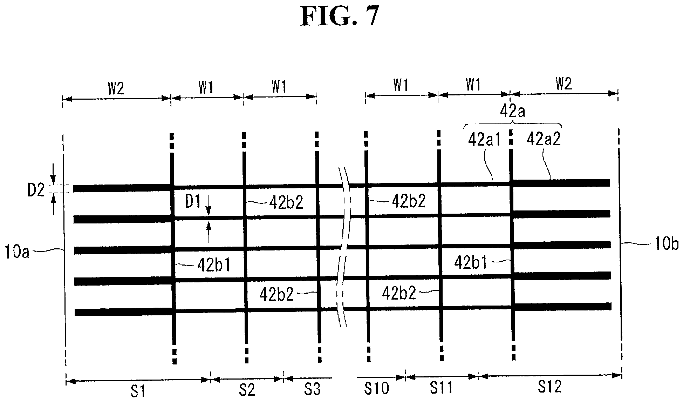

In the embodiment not part of the invention of FIG. 7, the finger line 42a includes a finger portion 42a1 having a first width D1 and an extension portion 42a2 having a second width D2 which is thicker than the first width D1.

The semiconductor substrate 10 is divided into the first to twelfth areas according to a position of the bus bar 42b. The first and the twelfth areas S1 and S12 refer to respective areas from the ends 10a and 10b of the semiconductor substrate 10 to the first bus bar 42b1 in the first direction and have a second width W2 that is greater than the width C1 of the chamfer 13.

The second to eleventh areas S2 to S11 are areas partitioned by the plurality of second bus bars 42b2 between the first and twelfth areas S1 and S12, all of which have a first width W1 in one example form. Therefore, an amount of current collected by the finger portion 42a1 in each of the areas S2 to S11 is the same. Therefore, the output loss occurring in each area can be adjusted to be the same.

The finger line 42a is formed of a linear finger portion 42a1 having a first width D1 in the second to eleventh areas S2 to S11, and a linear extension portion 42a2 having a second width D2 greater than the first width D1 in the first and twelfth areas S1 and S12.

The first width D1 is about 20 µm to 80 µm, and the second width D2 is about 1.5 to 3 times larger than the first width D1. However, the first width D1 and the second width D2 are not necessarily limited thereto. The first width D1 and the second width D2 are determined in consideration of various parameters such as a manufacturing method of the electrode, an interval between the finger lines 42a, and a forming material.

When the second width D2 is less than 1.5 times the first width D1, it is difficult to compensate the output loss occurring in the first area S1 and the twelfth area S12. When the second width D2 is greater than three times the first width D1, it is difficult to compensate the output loss due to a generation of shading loss because of a large area covered by the extension portion 42a2 in the first and the twelfth areas S1 and S12.

A pitch, which is a distance between the finger portions 42a1 in the second to eleventh areas S2 to S11, is substantially equal to a pitch of the extension portion 42a2 in the first and twelfth areas S1 and S12. In this specification, the pitch is a distance between two neighboring finger lines. For example, the pitch is a distance between centers of each of the two neighboring finger lines. Thus, an amount of current collected in the first and the twelfth areas and the second to eleventh areas S2 to S11 may be the same.

In this embodiment, the width of the finger line 42a disposed in the first and the twelfth areas S1 and S12 where the output loss is large is formed to be wide, thereby reducing the output loss. Also, since the finger portion 42a1 and the extension portion 42a2 are connected to each other in the first bus bar 42b1, an area where the first wiring positioned in the first bus bar 42b1 meets the electrodes becomes larger and the contact resistance decreases. Therefore, the output loss occurring in the first area S1 and the twelfth area S12 can be more effectively reduced.

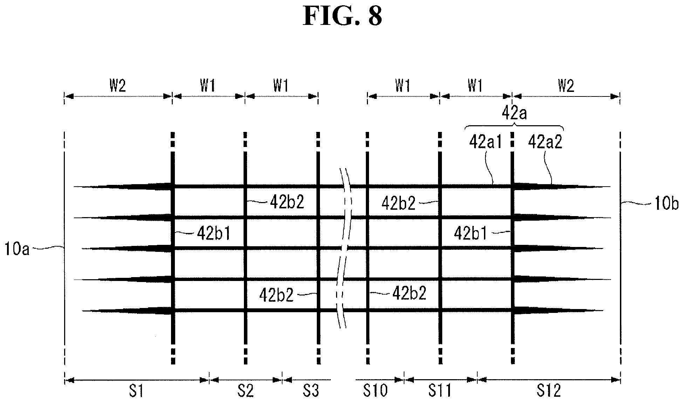

FIG. 8 is a modification of FIG. 7. FIG. 8 is the same as a finger line described in FIG. 7 except that an extension portion is formed in a needle shape that gradually decreases in width.

It can be seen from FIG. 5 that the output loss increases sharply as it gets closer to the first bus bar 42b1.

The extension portion 42a2 has a shape gradually increasing in width from the end 10a, 10b of the semiconductor substrate 10 toward the first bus bar 42b1. Since most of the output loss occurs at a position (HA in FIG. 5) close to the first bus bar 42b1 in the first area S1 or the twelfth area S12, the width of the extended portion 42a2 gradually decrease toward the end 10a or 10b of the semiconductor substrate 10. Therefore, the shading loss that increases in the first and twelfth areas S1 and S12 due to the extension portion 42a2 can be reduced.

The extension portion 42a2 has a maximum width at a position connected to the first bus bar 42b1 and a minimum width at an end. The maximum width is greater than the width of the finger portion 42a1 and, for example, 1.5 to 3.0 times the width of the finger portion 42al. The minimum width is equal to or smaller than the width of the finger portion 42a1.

FIG. 8 illustrates only one embodiment not part of the invention in which the extension portion 42a2 gradually increases toward the first bus bar 42b1. However, the invention is not necessarily limited to this. There may be modifications that the extension portion 42a2 is increased in stages toward the first bus bar 42b1, or the extension portion 42a2 has a second width D2 only at a position (HA in FIG. 5) adjacent to the first bus bar 42b1 and the remaining portion have the same first width D1 as the finger portion 42a1.

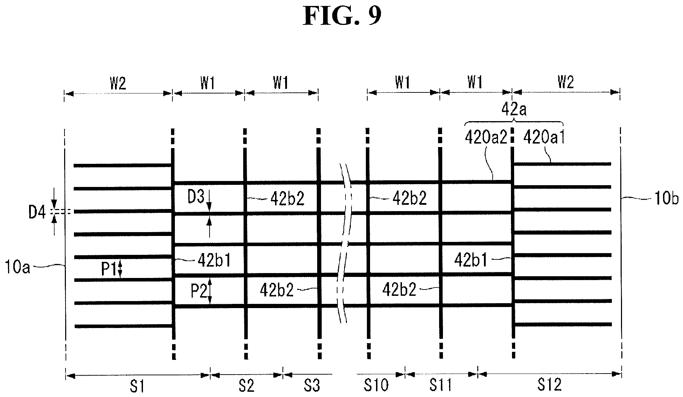

FIG. 9 illustrates a finger line of another embodiment not part of of the invention. In FIG. 9, the finger line 42a includes a first finger line 420a1 positioned in the first and twelfth areas S1 and S12 and a second finger line 420a2 positioned in the second to eleventh areas S2 to S11. The number of the first finger lines 420a1 is different from that of the second finger lines 420a2. For example, the number of the first finger lines 420a1 is 1.5 to 3 times the number of the second finger lines 420a2.

The second finger line 420a2 extends in parallel to the second finger line 420a2 adjacent to each other in the second to eleventh areas S2 to S11 with a second pitch P2. The second finger line 420a2 is a linear shape having a third width D3. Here, the second pitch P2 may be the same as the interval between the finger portions described in the embodiment of FIG. 7. The third width D3 may be equal to the width D1 of the finger portion. However, the invention is not limited thereto.

The first finger line 420a1 extends in parallel to the first finger line 420a1 adjacent to each other in the first and the twelfth areas S1 and S12 with a first pitch P1. The first finger line 420a1 is a linear shape having a fourth width D4. Here, the first pitch P1 is smaller than the second pitch P2. The fourth width D4 may be the same as or different from the third width D3.

In an example form, some of the first finger lines 420a1 may be formed by extending the second finger line 420a2 to the first and twelfth areas S1 and S12. However, the invention is not limited thereto. Since the first finger line 420a1 is connected to the second finger line 420a2 by the first bus bar 42b1, the second finger line 420a2 and the first finger line 420a1 do not necessarily have to be formed as one, and may be formed asymmetrically with respect to the first bus bar 42b1.

In the embodiment of FIG. 9, since the second pitch P2 of the second finger line 420a2 is greater than the first pitch P1 of the first finger line 420a1, the number of the first finger lines 420a1 positioned in the first and twelfth areas S1 and S12 is greater than the number of the second finger lines 420a2 positioned in the second to eleventh areas S2 to S11. Thus, the first and the twelfth areas S1 and S12 are wider than the second to eleventh areas S2 to S11, however, since the number of electrodes positioned in the first and twelfth areas S1 and S12 is greater than the number of electrodes positioned in the second to eleventh regions S2 to S11, the carriers can be effectively collected in the first and twelfth areas S1 and S12, and the output loss can be reduced.

The first finger line 420a1 and the second finger line 420a2 are connected to the first bus bar 42b1 so that the first finger line 420a1 and the second finger line 420a2 are electrically connected to each other.

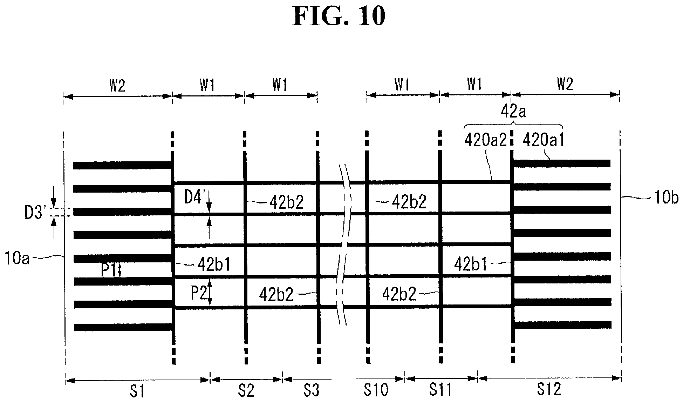

FIG. 10 is a modification of FIG. 9. FIG. 10 illustrates that a width of a first finger line 420a1 is configured to be greater than a width of a second finger line 420a2. In FIG. 10, a width D3' of the first finger line 420a1 is greater than a width D4' of the second finger line 420a2 and is, for example, 1.5 to 3.0 times the width D4'. However, the invention is not limited thereto. Also, in FIG. 10, the width of all the first finger lines 420a1 is greater than the width of the second finger lines 420a2. However, it is also possible that only a width of a part of the first finger line 420a1 is greater than the width of the second finger line 420a2.

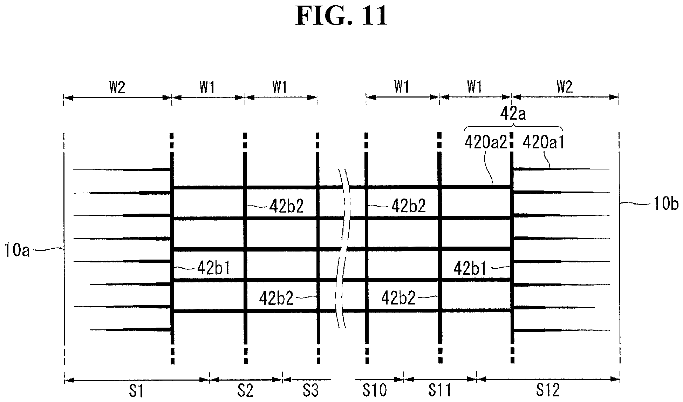

Also, in the embodiments of FIGS. 9 and 10, it is also possible that the first finger line 420a1 is a needle shape whose width gradually decreases similarly to that illustrated in FIG. 8. FIG. 11 illustrates that the first finger line 420a1 in the embodiment of FIG. 9 is formed in a needle shape.

In FIG. 11, the first finger line 420a1 has a needle shape that the width of the first finger line 420a1 gradually decreases from the first bus bar 42b1 toward the ends 10a and 10b of the semiconductor substrate 10. It is preferable that the first finger line 420a1 has a maximum width at a portion connected to the first bus bar 42b1 and a minimum width at the end.

Here, the maximum width of the first finger line 420a1 is, for example, at least equal to or greater than the width of the second finger line 420a2. The minimum width of the first finger line 420a1 is, for example, smaller than the width of the second finger line 420a2. However, the invention is not limited thereto.

In the above-described embodiments, the widths or the number of the finger lines 42a in the first and twelfth areas S1 and S12 and the second to eleventh areas S2 to S11 are different from each other. However, the invention is not limited thereto. For example, the finger lines positioned in at least one of the second to eleventh areas S2 to S11 may be different from the finger lines positioned in the remaining area.

Referring to FIG. 5, for example, the output loss gradually decreases from the area S1 toward the area S4, while the output loss in the areas S4 to S6 (corresponding to the central area of the semiconductor substrate) is all the same as 0.002. Through these experimental results, although the areas S2 to S4 are positioned apart from each other by W1, it can be seen that there is a difference in the output loss.

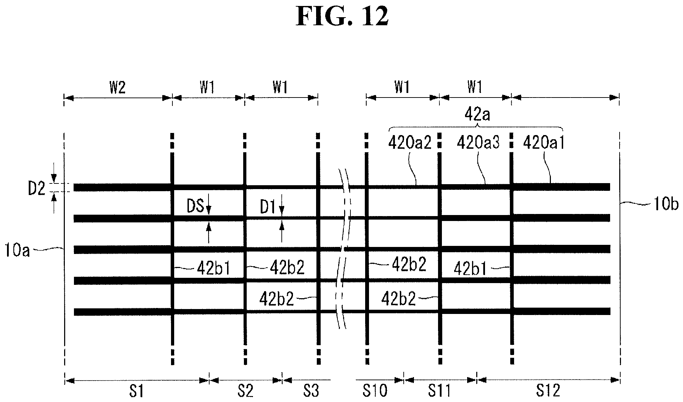

Considering this point, the finger lines 42a may be configured such that at least one area in the second to eleventh areas S2 to S11 is different in width or number as the finger lines positioned in the first or twelfth areas S1 and S12 of the embodiments in FIGS. 7 to 11. FIG. 12 illustrates a representative example not part of the invention in which the width is different.

The embodiment of FIG. 12 illustrates that a width DS of the electrode in the second area S2 and the eleventh area S11 in the embodiment described in FIG. 7 has a value between a width D2 of the extension portion and a width D1 of the finger portion.

In FIG. 12, the finger line 42a includes an extension portion 420a1, a finger portion 420a2, and a connection portion 420a3.

The finger portion 420a2 is formed in a straight line shape having the first width D1 in the third to tenth areas S3 to S10 and extends in parallel with the neighboring finger portion 420a2. The extension portion 420a1 is formed in a straight line shape having a second width D2 greater than the first width D1 in the first and the twelfth areas S1 and S12. The connection portion 420a3 is formed in a straight line shape having a middle width DS between the first width D1 and the second width D2 in the second and eleventh areas S2 and S11.

The finger portion 420a2 and the connection portion 420a3 are connected to each other by the second bus bar 42b2. The connection portion 420a3 and the extension portion 420a1 are connected to each other by the first bus bar 42b1.

In the embodiment of FIG. 12, the connection portions 420a3 are formed in the second and eleventh areas S2 and S11, respectively. However, the invention is not limited thereto. The connection portions 420a3 may be formed in at least one of the second to eleventh areas.

Furthermore, the configuration in which the widths or the numbers of the electrodes described in the embodiments of FIGS. 7 to 11 are different can be applied to the embodiment of FIG. 12 in the same or similar manner. For example, in the second and eleventh areas S2 and S11, the finger lines may have a needle shape or a configuration in which the number of electrodes is increased.

Hereinafter, effects of the above-described embodiments will be described.

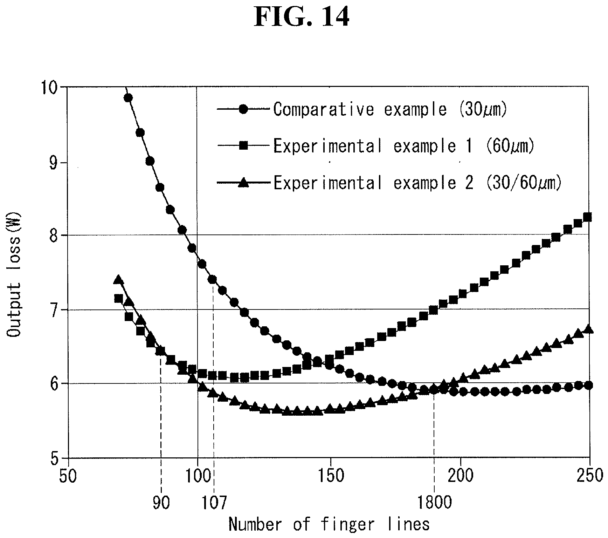

In this experiment, when a width of the finger line is 30 µm, the number of finger lines in which output loss is minimized in the second to eleventh areas S2 to S11 is determined (FIG. 13). Accordingly, it is determined whether which embodiment of the finger line can effectively reduce output loss in the first area S1 (FIG. 14). This experiment is directed to the embodiments according to FIG. 7 and FIG. 8.

FIG. 13 illustrates a result of an experiment to determine output loss according to the number of finger lines in the second to eleventh areas. A width of the finger lines used in this experiment is 30 µm, and a shape is a straight line shape.

FIG. 14 illustrates a result of an experiment to determine output loss according to the number of finger lines in the first area S1. The experiment was performed under the same conditions as the experiment of FIG. 13.

Experimental example 1 illustrates a result of an experiment in which the finger line has an extension portion having a straight line shape as in the embodiment illustrated in FIG. 7. In the experimental example 1, the width of the finger line in the first area S1 is 60 µm.

Experimental example 2 illustrates a result of an experiment in which the finger line has an extension portion having a tapered shape as in the embodiment illustrated in FIG. 8. In the experimental example 2, the maximum width of the finger lines in the first area is 60 µm and the minimum width of the finger lines in the first area is 30 µm.

The comparative example is for examining the effects of the experimental examples 1 and 2. The comparative example illustrates experimental results of the output loss in a case where there is no change in the width or the number of the finger lines in the first area. That is, the finger line has a width of 30 µm in the entire area.

Referring to FIG. 13, when the width of the finger line is 30 µm, the number of finger lines is about 107, which means that the output loss is the smallest.

Referring to FIG. 14, when the number of finger lines is about 107, the output loss is about 7.4 W in the comparative example, the output loss is reduced to about 6.1 W in the experimental example 1, and the output loss is reduced to about 5.6 W in the experimental example 2.

Thus, according to an embodiment of the invention (for example, FIG. 7), the output loss can be reduced by about 1.3 W compared with the comparative example. According to another embodiment of the invention (for example, FIG. 8), the output loss can be reduced by about 1.8 W compared with the comparative example.

Also, the experimental example 2 is more effective than the experimental example 1 in reducing output loss when the experimental example 1 is compared with the experimental example 2.

Meanwhile, the above embodiments are directed to a solar cell and a solar cell panel using the same in which a first electrode 42 and a second electrode 44 are disposed on a front surface and a back surface of a semiconductor substrate, respectively. However, the invention is not limited thereto.

The embodiments of FIGS. 7 and 8 of the above-described embodiments can be similarly applied to a back contact type solar cell in which both the first electrode and the second electrode are disposed on the back surface of the semiconductor substrate.

Hereinafter, an embodiment in which the embodiment of FIG. 7 is implemented in a back contact type solar cell will be briefly described as an example.

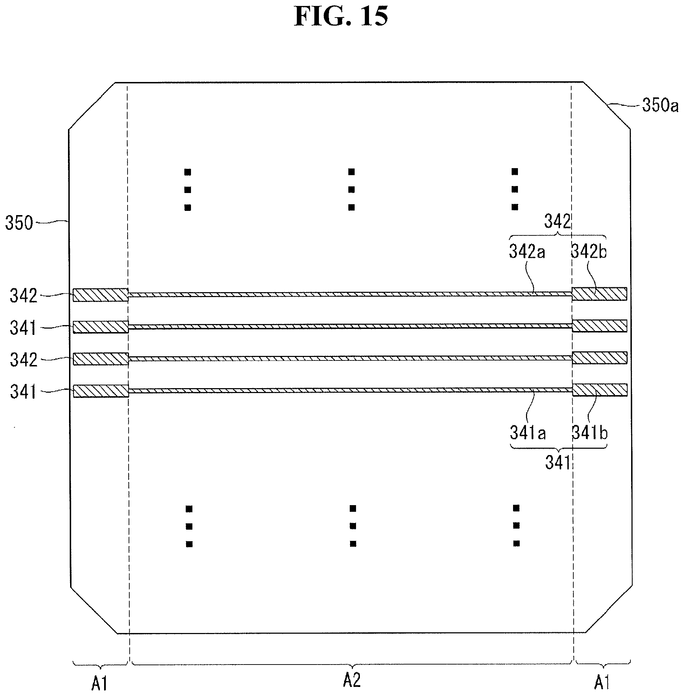

FIG. 15 illustrates an embodiment in which an extension portion is formed in an outer area including a chamfer 350a in a back contact type solar cell. In FIG. 15, only a first electrode 341 and a second electrode 342 are selectively enlarged.

In FIG. 15, the first electrode 341 and the second electrode 342 are alternately arranged on a back surface of a semiconductor substrate 350 and arranged side by side in one direction. Here, the first electrode 341 is in contact with a first conductivity type region, and the second electrode 342 is in contact with a second conductivity type region.

The semiconductor substrate 350 is divided into a first area A1 in which the chamfer 350a is included in a part of an area from an end of the semiconductor substrate 350 and a second area A2 between the first areas A1.

The first electrode 341 includes a finger portion 341a and an extension portion 341b. The second electrode 342 includes a finger portion 342a and an extension portion 342b. The finger portions 341a and 342a are positioned in the second area A2 and have a certain width and extend in parallel with the neighboring finger portion. The extension portions 341b and 342b have a greater width than a width of the finger portions 341a and 342a in the first area A1. The extension portions 341b and 342b are connected to the finger portions 341a and 342a at a boundary between the first area A1 and the second area A2.

Although embodiments have been described with reference to a number of illustrative embodiments thereof, it should be understood that numerous other modifications and embodiments can be devised by those skilled in the art that will fall within the scope of the claims. More particularly, various variations and modifications are possible in the component parts and/or arrangements of the subject combination arrangement within the scope of the appended claims. In addition to variations and modifications in the component parts and/or arrangements, alternative uses will also be apparent to those skilled in the art.

## Claims

1. A solar cell, comprising:
a semiconductor substrate having a chamfer formed at each edge of the semiconductor substrate; and
an electrode electrically connected to the semiconductor substrate through a conductivity type region,
wherein the electrode includes:
a plurality of finger lines (42a) extending in a first direction, and
a plurality of bus bars (42b) positioned in a second direction intersecting the first direction and connecting the plurality of finger lines,
wherein the plurality of bus bars include:
a pair of first bus bars (42b1) respectively positioned at opposite ends of the semiconductor substrate along the first direction and a plurality of second bus bars (42b2) positioned between the pair of first bus bars,
wherein the plurality of finger lines (42a) includes a plurality of first finger lines (420a1) positioned in a first area defined between each end of said opposite ends of the semiconductor substrate and the corresponding adjacent first bus bar and a plurality of second finger lines (420a2) positioned in a second area between the pair of first bus bars,
wherein the plurality of first finger lines (420a1) positioned in the first area have different shapes from the plurality of second finger lines (420a2) positioned in the second area,
wherein a first width (W1) between neighboring second bus bars (42b2) of the plurality of second bus bars and between each first bus bar (42b1) and the adjacent second bus bar (42b2) is smaller than a second width (W2) between each of said opposite ends of the semiconductor substrate and the adjacent first bus bar of the pair of first bus bars (42b1),
wherein the second width (W2) is greater than a width (C1) of the chamfer along the first direction,
wherein a first line width (D3') of the plurality of first finger lines (420a1) positioned in the first area is greater than a second line width (D4') of the plurality of second finger lines (420a2) positioned in the second area,
wherein a number of the plurality of first finger lines (420a1) positioned in the first area is greater than a number of the plurality of second finger lines (420a2) positioned in the second area, and
wherein a first pitch (P1) of the plurality of first finger lines (420a1) positioned in the first area is smaller than a second pitch (P2) of the plurality of second finger lines (420a2) positioned in the second area.

2. The solar cell of claim 1, wherein the first line width is 1.5 to 3.0 times the second line width.

3. The solar cell of claim 1, wherein the first line width gradually decreases toward the one end of the semiconductor substrate.

4. The solar cell of any one preceding claim, wherein the second width is 1/11 to 1/9.5 of a width of the semiconductor substrate in the first direction.

5. The solar cell of any one preceding claim, wherein a number of the plurality of bus bars (42b) is 10 to 20.

6. A solar cell panel, comprising:
a front substrate;
a back substrate facing the front substrate;
a plurality of solar cells according to claim 1 positioned between the front substrate and the back substrate and connected to neighboring solar cells by 10 to 20 of a plurality of wirings; and
a sealing material surrounding the plurality of solar cells.

7. The solar cell panel of claim 6, wherein the plurality of wirings are positioned corresponding to the plurality of bus bars, respectively, and, wherein a width of the plurality of wirings is 250 µm to 500 µm.

8. The solar cell panel of claim 7, a number of the plurality of bus bars is equal to the number of the plurality of wirings (142).

## Patentansprüche

1. Solarzelle umfassend:
ein Halbleitersubstrat mit einer an jeder Kante des Halbleitersubstrats gebildeten Fase; und
eine Elektrode, die durch einen Leitfähigkeitstypbereich elektrisch mit dem Halbleitersubstrat verbunden ist,
wobei die Elektrode umfasst:
eine Mehrzahl von Fingerleitungen (42a), die sich in einer ersten Richtung erstrecken, und
eine Mehrzahl von Sammelschienen (42b), die in einer zweiten Richtung positioniert sind, die die erste Richtung schneidet, und die Mehrzahl von Fingerleitungen verbinden,
wobei die Mehrzahl von Sammelschienen umfasst:
ein Paar erster Sammelschienen (42b1), die jeweils an gegenüberliegenden Enden des Halbleitersubstrats entlang der ersten Richtung positioniert sind, und
eine Mehrzahl zweiter Sammelschienen (42b2), die zwischen dem Paar erster Sammelschienen positioniert sind,
wobei die Mehrzahl von Fingerleitungen (42a) eine Mehrzahl erster Fingerleitungen (420a1), die in einem ersten Bereich positioniert sind, der zwischen jedem Ende der gegenüberliegenden Enden des Halbleitersubstrats und der entsprechenden benachbarten ersten Sammelschiene definiert ist, und eine Mehrzahl zweiter Fingerleitungen (420a2) umfasst, die in einem zweiten Bereich zwischen dem Paar erster Sammelschienen positioniert sind,
wobei die Mehrzahl erster Fingerleitungen (420a1), die im ersten Bereich positioniert sind, von der Mehrzahl zweiter Fingerleitungen (420a2) verschiedene Formen aufweist, die im zweiten Bereich positioniert sind,
wobei eine erste Breite (W1) zwischen benachbarten zweiten Sammelschienen (42b2) der Mehrzahl zweiter Sammelschienen und zwischen jeder ersten Sammelschiene (42b1) und der benachbarten zweiten Sammelschiene (42b2) kleiner ist als eine zweite Breite (W2) zwischen jedem der gegenüberliegenden Enden des Halbleitersubstrats und der benachbarten ersten Sammelschiene des Paars erster Sammelschienen (42b1),
wobei die zweite Breite (W2) größer als eine Breite (C1) der Fase entlang der ersten Richtung ist,
wobei eine erste Leitungsbreite (D3') der Mehrzahl erster Fingerleitungen (420a1), die im ersten Bereich positioniert sind, größer ist als eine zweite Leitungsbreite (D4') der Mehrzahl zweiter Fingerleitungen (420a2), die im zweiten Bereich positioniert sind,
wobei eine Anzahl der Mehrzahl erster Fingerleitungen (420a1), die im ersten Bereich positioniert sind, größer ist als eine Anzahl der Mehrzahl zweiter Fingerleitungen (420a2), die im zweiten Bereich positioniert sind, und
wobei ein erster Abstand (P1) der Mehrzahl erster Fingerleitungen (420a1), die im ersten Bereich positioniert sind, kleiner ist als ein zweiter Abstand (P2) der Mehrzahl zweiter Fingerleitungen (420a2), die im zweiten Bereich positioniert sind.

2. Solarzelle nach Anspruch 1, wobei die erste Leitungsbreite das 1,5- bis 3,0-fache der zweiten Leitungsbreite beträgt.

3. Solarzelle nach Anspruch 1, wobei die erste Leitungsbreite zum einen Ende des Halbleitersubstrats hin allmählich abnimmt.

4. Solarzelle nach einem der vorhergehenden Ansprüche, wobei die zweite Breite 1/11 bis 1/9,5 einer Breite des Halbleitersubstrats in der ersten Richtung beträgt.

5. Solarzelle nach einem der vorhergehenden Ansprüche, wobei eine Anzahl der Mehrzahl von Sammelschienen (42b) 10 bis 20 beträgt.

6. Solarzellenpanel umfassend:
ein vorderes Substrat;
ein hinteres Substrat, das dem vorderen Substrat zugewandt ist;
eine Mehrzahl von Solarzellen nach Anspruch 1, die zwischen dem vorderen Substrat und dem hinteren Substrat angeordnet sind und mit benachbarten Solarzellen durch 10 bis 20 einer Mehrzahl von Verdrahtungen verbunden sind; und
ein Dichtungsmaterial, das die Mehrzahl von Solarzellen umgibt.

7. Solarzellenpanel nach Anspruch 6, wobei die Mehrzahl von Verdrahtungen jeweils entsprechend der Mehrzahl von Sammelschienen positioniert ist und wobei eine Breite der Mehrzahl von Verdrahtungen 250 µm bis 500 µm beträgt.

8. Solarzellenpanel nach Anspruch 7, wobei eine Anzahl der Mehrzahl von Sammelschienen gleich der Anzahl der Mehrzahl von Verdrahtungen (142) ist.

## Revendications

1. Cellule solaire comprenant :
un substrat à semi-conducteur ayant un chanfrein formé sur chaque bord du substrat à semi-conducteur ; et
une électrode connectée électriquement au substrat à semi-conducteur par une région de type conductivité,
l'électrode comprenant :
une pluralité de lignes de doigts (42a) s'étendant dans une première direction, et
une pluralité de barres omnibus (42b) positionnées dans une seconde direction croisant la première direction et connectant la pluralité de lignes de doigts,
la pluralité de barres omnibus comprenant :
une paire de premières barres omnibus (42b1) positionnées respectivement à des extrémités opposées du substrat à semi-conducteur dans la première direction et une pluralité de secondes barres omnibus (42b2) positionnées entre la paire de premières barres omnibus,
la pluralité de lignes de doigts (42a) comprenant une pluralité de premières lignes de doigts (420a1) positionnées dans une première zone définie chacune desdites extrémités opposées du substrat à semi-conducteur et la première barre omnibus adjacente correspondante et une pluralité des secondes lignes de doigts (420a2) positionnées dans une seconde zone entre la paire des premières barres omnibus,
la pluralité des premières lignes de doigts (420a1) positionnées dans la première zone ayant des formes différentes de la pluralité des secondes lignes de doigts (420a2) positionnées dans la seconde zone,
une première largeur (W1) entre des secondes barres omnibus voisines (42b2) de la pluralité des secondes barres omnibus et entre chaque première barre omnibus (42b1) et la seconde barre omnibus adjacente (42b2) étant inférieure à une seconde largeur (W2) entre chacune desdites extrémités opposées du substrat à semi-conducteur et la première barre omnibus adjacente de la paire des premières barres omnibus (42b1),
la seconde largeur (W2) étant supérieure à une largeur (C1) du chanfrein dans la première direction,
une première largeur de ligne (D3') de la pluralité des premières lignes de doigt (420a1) positionnées dans la première zone étant supérieure à une seconde largeur de ligne (D4') de la pluralité des secondes lignes de doigts (420a2) positionnées dans la seconde zone,
un nombre de la pluralité des premières lignes de doigts (420a1) positionnées dans la première zone étant supérieur à un nombre de la pluralité des secondes lignes de doigts (420a2) positionnées dans la seconde zone, et
un premier pas (P1) de la pluralité des premières lignes de doigts (420a1) positionnées dans la première zone étant inférieur à un second pas (P2) de la pluralité des secondes lignes de doigts (420a2) positionnées dans la seconde zone.

2. Cellule solaire selon la revendication 1, la largeur de première ligne étant 1,5 à 3,0 fois la largeur de seconde ligne.

3. Cellule solaire selon la revendication 1, la première largeur de ligne décroissant graduellement en direction d'une extrémité du substrat à semi-conducteur.

4. Cellule solaire selon l'une quelconque revendication précédente, la seconde largeur étant comprise entre 1/11 et 1/9,5 d'une largeur du substrat à semi-conducteur dans la première direction.

5. Cellule solaire selon l'une quelconque revendication précédente, le nombre de la pluralité de barres omnibus (42b) étant entre 10 et 20.

6. Panneaux de cellules solaires, comprenant :
un substrat avant ;
un substrat arrière faisant face au substrat avant ;
une pluralité de cellules solaires selon la revendication 1, positionnées entre le substrat avant et le substrat arrière et connectées aux cellules solaires voisines par 10 ou 20 d'une pluralité de câblages, et
un matériau d'étanchéité entourant la pluralité de cellules solaires.

7. Panneaux de cellules solaires selon la revendication 6, la pluralité de câblages étant dans des positions correspondant à la pluralité des barres omnibus, respectivement, et
une largeur de la pluralité de câblages étant comprise entre 250 µm et 500 µm.

8. Panneaux de cellules solaires selon la revendication 7, le nombre de la pluralité de barres omnibus étant égal au nombre de la pluralité de câblages (142).
